Europäisches Patentamt

European Patent Office

Office européen des brevets

(11) Veröffentlichungsnummer: **0 477 686 A1**

# (12) EUROPÄISCHE PATENTANMELDUNG

(21) Anmeldenummer: **91115457.3**

(22) Anmeldetag: **12.09.91**

(51) Int. Cl.⁵: **G03F 7/11**, G03F 7/032, G03F 7/021

(30) Priorität: **22.09.90 DE 4030056**

(43) Veröffentlichungstag der Anmeldung:
**01.04.92 Patentblatt 92/14**

(84) Benannte Vertragsstaaten:
**CH DE FR GB LI**

(71) Anmelder: **HOECHST AKTIENGESELLSCHAFT**
**Postfach 80 03 20**
**W-6230 Frankfurt am Main 80(DE)**

(72) Erfinder: **Konrad, Klaus Peter, Dr.**
**Schlossstrasse 35**
**W-6501 Dexheim(DE)**
Erfinder: **Joerg, Klaus, Dr.**
**Winkelerstrasse 2 B**
**W-6507 Ingelheim(DE)**
Erfinder: **Buhr, Gerhard, Dr.**
**Am Erdbeerstrasse 28**
**W-6240 Königstein 4(DE)**
Erfinder: **Pliefke, Engelbert, Dr.**
**Drussusstrasse 52**
**W-6200 Wiesbaden(DE)**

(54) **Lichtempfindliches Aufzeichnungsmaterial.**

(57) Es wird ein lichtempfindliches Aufzeichnungsmaterial mit einem Schichtträger, einer lichtempfindlichen Schicht, die ein Diazoniumsalz-Polykondensationsprodukt, eine radikalisch polymerisierbare Verbindung, einen Photoinitiator und ein polymeres Bindemittel enthält, und einer Deckschicht beschrieben, die ein für Luftsauerstoff wenig durchlässiges wasserlösliches Polymeres und ein wasserlösliches saures Phosphat, insbesondere ein primäres Ammonium-, Natrium- oder Kaliumphosphat, enthält. Das Material zeichnet sich durch hohe Lichtempfindlichkeit, gute Lagerfähigkeit und geringe Klebeneigung aus. Es ist insbesondere zur Herstellung von Flachdruckplatten hoher Auflagenleistung geeignet.

EP 0 477 686 A1

Die Erfindung betrifft ein lichtempfindliches, negativ arbeitendes Aufzeichnungsmaterial mit einem Schichtträger, einer lichtempfindlichen Schicht, die als wesentliche Bestandteile

a) ein Diazoniumsalz-Polykondensationsprodukt,

b) eine radikalisch polymerisierbare Verbindung mit mindestens einer endständigen ethylenisch ungesättigten Gruppe und einem Siedepunkt bei Normaldruck oberhalb 100 ° C,

c) einen unter Einwirkung aktinischer Strahlung Radikale bildenden Polymerisationsinitiator und

d) ein polymeres Bindemittel enthält.

Aufzeichnungsmaterialien der genannten Gattung, die eine Kombination eines photopolymerisierbaren Gemischs mit einem lichthärtbaren Diazoniumsalz-Polykondensationsprodukt enthalten, sind aus den DE-A 23 61 931, 29 03 270 und 30 07 212 (= GB-A 2 044 788) bekannt. Als Vorteil wird vor allen die bessere Auflösung der Kopie gegenüber reinen photopolymerisierbaren Schichten und die erhöhte Druckauflage gegenüber Schichten angegeben, die allein Diazoverbindungen als lichtempfindliche Substanzen enthalten. Auch ist es in bestimmten Fällen möglich, die Entwicklung mit wäßrigen Lösungen oder sogar mit reinem Wasser durchzuführen.

In der EP-A 167 963 wird ein lichtempfindliches Gemisch aus den oben genannten Bestandteilen beschrieben, das als Diazoniumsalz-Kondensationsprodukt ein Polykondensationsprodukt aus wiederkehrenden Einheiten A-$N_2$X und B enthält, die durch Zwischenglieder, vorzugsweise Methylengruppen, miteinander verbunden sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines phenols, Phenolethers, aromatischen Thioethers, eines aromatischen Kohlenwasserstoffs, einer aromatischen heterocyclischen Verbindung oder eines organischen Säureamids ist. Das Gemisch liefert Druckplatten mit hoher Auflage, wenn es ein wasserunlösliches Bindemittel enthält. In diesem Fall erfordert es den Zusatz organischer Lösemittel zum Entwickler.

In der EP-A 211 391 wird ein entsprechendes Gemisch beschrieben, das als Bindemittel das Umsetzungsprodukt eines Di- oder Tricarbonsäureanhydrids mit einer freie Hydroxygruppen enthaltenden polymeren organischen Verbindung enthält. Die damit erhaltenen Druckplatten lassen sich mit wäßrigen Lösungen ohne größeren Zusatz organischer Lösemittel entwickeln und ergeben ebenfalls hohe Auflagen. Die lichtempfindlichen Schichten aus diesem Gemisch sind aber bei erhöhter Temperatur klebrig und müssen daher mit einer nichtklebrigen Deckschicht, z. B. aus Polyvinylalkohol, versehen werden. Auch wird durch diese Schicht, die als Sperrschicht für Luftsauerstoff wirkt, die Durchhärtung der lichtempfindlichen Schicht verbessert.

In der EP-A 381 043 wird ein lichtempfindliches Gemisch der vorstehend angegebenen Zusammensetzung beschrieben, das als weiteres Bindemittel ein saures organisches Polymeres mit einer Säurezahl oberhalb 70, vorzugsweise ein (Meth)acrylsäurecopolymeres, enthält. Das damit hergestellte Aufzeichnungsmaterial, z. B. eine vorsensibilisierte Druckplatte, hat den Vorteil, daß seine Lagerfähigkeit durch den Zusatz des Polymeren mit höherer Säurezahl verbessert wird. Es trägt bevorzugt auf der lichtempfindlichen Schicht eine sauerstoffhemmende Deckschicht aus einem wasserlöslichen Polymeren.

Diese auch bei reinen photopolymerisierbaren Schichten übliche Deckschicht enthält bei den vorstehend beschriebenen Kombinationsschichten gewöhnlich noch einen Zusatz von Mineralsäure, bevorzugt Phosphorsäure, um die Lagerfähigkeit der Diazoniumsalz-Kondensationsprodukte enthaltenden Schichten zu verbessern. Durch diesen Zusatz verlieren jedoch diese Deckschichten ihre oben erwähnte Fähigkeit, die Klebrigkeit der Oberfläche von Materialien, die niedermolekulare polymerisierbare Verbindungen enthalten, anhaltend zu beseitigen. Bei Versuchen, diesen Nachteil durch Reduzierung der Säuremenge zu begrenzen, wurde gefunden, daß dabei auch die stabilisierende Wirkung auf die lichtempfindliche Schicht weitgehend verlorengeht.

Aufgabe der Erfindung war es daher, ein lichtempfindliches Aufzeichnungsmaterial mit einer lichtempfindlichen Schicht vorzuschlagen, die ein Diazoniumsalz-Polykondensationsprodukt und ein photopolymerisierbares Gemisch enthält. Das Material sollte eine gute Lagerfähigkeit mit geringer Klebeneigung verbinden und zugleich eine gute Lichtempfindlichkeit aufweisen.

Erfindungsgemäß wird ein lichtempfindliches Aufzeichnungsmaterial mit einem Schichtträger und einer lichtempfindlichen Schicht, die als wesentliche Bestandteile

a) ein Diazoniumsalz-Polykondensationsprodukt,

b) eine radikalisch polymerisierbare Verbindung mit mindestens einer endständigen ethylenisch ungesättigten Gruppe und einem Siedepunkt bei Normaldruck oberhalb 100 ° C,

c) einen unter Einwirkung aktinischer Strahlung Radikale bildenden Polymerisationsinitiator und

d) ein polymeres Bindemittel enthält,

und einer Deckschicht vorgeschlagen, die ein für Luftsauerstoff wenig durchlässiges wasserlösliches Polymeres enthält.

2

Das erfindungsgemäße Aufzeichnungsmaterial ist dadurch gekennzeichnet, daß die Deckschicht zusätzlich ein wasserlösliches saures Phosphat enthält.

Die wäßrige Beschichtungslösung für die Deckschicht sollte ein pH im Bereich von 3 bis 7, vorzugsweise von 4 bis 6, aufweisen.

Als wasserlösliche saure Phosphate sind insbesondere Ammonium-, Alkali- oder Erdalkaliphosphate geeignet. Die Ammoniumphosphate können auch alkylsubstituierte Ammoniumionen enthalten, die rein anorganischen Ammoniumsalze werden jedoch bevorzugt. Von den Erdalkalisalzen sind insbesondere Magnesium- und Calciumsalze geeignet; von den Alkalien werden Natrium und Kalium, ganz besonders das Natrium, bevorzugt. Die sauren Phosphate liegen vorzugsweise mindestens zum Teil als primäre, d. h. Dihydrogenphosphate vor. Sie können im Gemisch mit sekundären Phosphaten vorliegen, wobei zu beachten ist, daß der pH-Wert der Lösung in dem oben angegebenen Bereich liegt. Das kann z. B. auch durch Zusatz von entsprechenden Mengen Phosphorsäure zu einer Lösung eines sekundären oder tertiären Phosphats erreicht werden. Die Beschichtungslösungen enthalten im allgemeinen 0,05 bis 5, vorzugsweise 0,1 bis 2 Gew.-% an Phosphat. Das Phosphat liegt grundsätzlich als Orthophosphation vor, es kann jedoch auch in untergeordneter Menge Anteile an höheren, z. B. Diphosphaten, enthalten.

Hauptbestandteil der Deckschicht ist in an sich bekannter Weise ein wasserlösliches Polymeres. Das für Luftsauerstoff wenig durchlässige Polymere kann eines der in der US-A 3 458 311 angegebenen Polymeren sein. Beispiele sind insbesondere Polyvinylalkohol und teilverseifte Polyvinylacetate, die auch Vinylether- und Vinylacetaleinheiten enthalten können, solange das Polymere bei 20 °C wasserlöslich bleibt. Ferner können Gelatine, Gummi arabicum, Mischpolymerisate von Alkylvinylethern und Maleinsäureanhydrid, Polyvinylpyrrolidone und wasserlösliche hochmolekulare Polymerisate von Ethylenoxid (M = 100 000 bis 3 000 000) eingesetzt werden. Bevorzugt werden solche Polymere, deren Sauerstoffdurchlässigkeit in einer Schicht bei 20 °C kleiner als 30, insbesondere kleiner als 25 $cm^3/m^2/d/bar$ ist. Besonders bevorzugt wird Polyvinylalkohol, insbesondere Polyvinylalkohole mit Molekulargewichten zwischen 5000 und 50 000 ($P_n$ zwischen 200 und 1000) und Hydrolysegraden zwischen 65 und 95 %, insbesondere zwischen 70 und 90 %. Der Anteil dieser Polymeren beträgt 50-95, vorzugsweise 60-90 % des Gesamtfeststoffgehalts der Deckschicht.

Der Deckschicht können zur besseren Benetzung bis zu 10 Gew.-%, vorzugsweise bis zu 5 Gew.-% eines oberflächenaktiven Mittels, bezogen auf ihren Feststoffgehalt, zugesetzt werden. Zu den brauchbaren oberflächenaktiven Substanzen gehören die anionischen, kationischen und nichtionischen oberflächenaktiven Mittel, z. B. Natriumalkylsulfate und -sulfonate mit 12 bis 18 Kohlenstoffatomen wie Natriumdodecylsulfat, N-Cetyl- und C-Cetylbetaine, Alkylaminocarboxylate und -dicarboxylate, Polyethylenglykole mit einem durchschnittlichen Molekulargewicht bis 400 sowie Monoether von Polyethylenglykolen.

Die Deckschicht kann weiterhin Konservierungsstoffe, z. B. Fungizide, oder Farbstoffe in kleiner Menge enthalten. Sie wird in an sich bekannter Weise aus wäßriger Lösung, der ggf. mischbare organische Lösemittel zugesetzt werden können, auf die lichtempfindliche Schicht aufgebracht. Sie hat im allgemeinen ein Schichtgewicht von 0,1 bis 10, vorzugsweise von 0,2 bis 3 $g/m^2$.

Negativ arbeitende lichtempfindliche Schichten, wie sie bei dem erfindungsgemäßen Aufzeichnungsmaterial eingesetzt werden, sind bekannt und z. B. in den EP-A 167 963, 211 391 und 381 043 beschrieben. Sie enthalten stets die eingangs genannten vier wesentlichen Bestandteile.

Als Diazoniumsalz-Polykondensationsprodukte sind Kondensationsprodukte kondensationsfähiger aromatischer Diazoniumsalze, z. B. von Diphenylamin-4-diazoniumsalzen, mit Aldehyden, bevorzugt Formaldehyd, geeignet. Mit besonderem Vorteil werden Mischkondensationsprodukte verwendet, die außer den Diazoniumsalzeinheiten noch andere, nicht lichtempfindliche Einheiten enthalten, die von kondensationsfähigen Verbindungen, insbesondere aromatischen Aminen, Phenolen, Phenolethern, aromatischen Kohlenwasserstoffen, aromatischen Heterocyclen und organischen Säureamiden, abgeleitet sind. Diese Kondensationsprodukte sind in der DE-C 20 24 244 beschrieben. Allgemein sind alle Diazoniumsalz-Polykondensationsprodukte geeignet, die in der DE-A 27 39 774 beschrieben sind.

Die Diazoniumsalzeinheiten A-$N_2$X leiten sich bevorzugt von Verbindungen der Formel ($R^1$-$R^2$-)$_p R^3$-$N_2$X ab, wobei

X       das Anion der Diazoniumverbindung,

p       eine ganze Zahl von 1 bis 3,

$R^1$     einen aromatischen Rest mit mindestens einer zur Kondensation mit aktiver Carbonylverbindung befähigten Position,

$R^3$     eine Phenylengruppe,

$R^2$     eine Einfachbindung oder eine der Gruppen:

-($CH_2$)$_q$-$NR^4$-,

-O-(CH$_2$)$_r$-NR$^4$-,

-S-(CH$_2$)$_r$-NR$^4$-,

-S-CH$_2$CO-NR$^4$-,

-O-R$^5$-O-,

- O -,

- S - oder

-CO-NR$^4$-

bedeuten, worin

q      eine Zahl von 0 bis 5,

r      eine Zahl von 2 bis 5,

R$^4$      Wasserstoff, eine Alkylgruppe mit 1 bis 5 C-Atomen, eine Aralkylgruppe mit 7 bis 12 C-Atomen oder eine Arylgruppe mit 6 bis 12 C-Atomen, und

R$^5$      eine Arylengruppe mit 6 bis 12 C-Atomen ist.

Von den genannten Verbindungsklassen werden die Kondensationsprodukte der Diphenylamin-4-diazoniumsalze, die gegebenenfalls durch Alkyl-, Alkoxygruppen oder Halogenatome substituiert sind, bevorzugt. Als Zweitkomponenten B werden die gegebenenfalls substituierten Diphenylether, Diphenylsulfide, Diphenylmethane oder Diphenyle bevorzugt. Dabei werden für die Kondensation die Bis-methoxymethyl-, Bishydroxymethyl- oder Bis-acetoxymethylderivate der Grundkörper mit besonderem Vorteil eingesetzt. Das Kondensationsprodukt kann im Mittel 0,1 bis 50, bevorzugt 0,2 bis 20 Einheiten B je Einheit A-N$_2$X enthalten.

Der Mengenanteil des Diazoniumsalz-Polykondensationsprodukts in dem Gemisch liegt im allgemeinen zwischen 5 und 60, vorzugsweise zwischen 10 und 40 Gew.-%, bezogen auf den Gesamtgehalt an nichtflüchtigen Bestandteilen.

Weitere besonders vorteilhafte Polykondensationsprodukte werden erhalten, indem ein ggf. substituiertes Diphenylamindiazoniumsalz zuerst mit einer aromatischen Verbindung R'-O-CH$_2$-BH und danach mit einer aromatischen Verbindung R'-O-CH$_2$-B-CH$_2$-O-R' kondensiert wird, wobei R' ein Wasserstoffatom, ein Alkyl- oder aliphatischer Acylrest ist. Diese Kondensationsprodukte sind in der EP-A 126 875 beschrieben.

Als radikalisch polymerisierbare Verbindungen werden bevorzugt Acryl- oder Methacrylsäureester von ein- oder mehrwertigen, insbesondere primären Alkoholen eingesetzt. Die Alkohole können 1 bis 6, bevorzugt 2 bis 4 OH-Gruppen enthalten. Beispiele für geeignete Ester sind Trimethylolpropantriacrylat, Pentaerythrittri- und -tetraacrylat, Dipentaerythrithexamethacrylat, Propylenglykoldimethacrylat, Glycerindimethacrylat, Triethylenglykoldimethacrylat, Polyethylenglykoldiacrylat und Bisacrylate von oxyethylierten Bisphenol-A-Derivaten. Es sind auch die niedermolekularen, Urethangruppen enthaltenden Acrylate und Methacrylate geeignet, die durch Umsetzen von Hydroxyalkylacrylat oder -methacrylat mit zwei- oder mehrwertigen Isocyanaten erhalten werden. Die Isocyanate können wiederum durch Umsetzen von Diisocyanaten mit Diolen oder Triolen zu oligomeren Verbindungen erhalten worden sein. Die Menge an polymerisierbaren Verbindungen liegt im allgemeinen zwischen 10 und 65, bevorzugt bei 30 bis 60 Gew.-%.

Als Photoinitiatoren können eine Vielzahl von Verbindungen, gegebenenfalls auch Gemische von zwei oder mehreren verschiedenen, oftmals synergistisch wirkenden Verbindungen Verwendung finden. Beispiele sind Benzoin und seine Derivate, Mehrkernchinone, Acridinderivate, Phenazinderivate, aromatisch substituierte Oxdiazole, z. B. 2,5-Bis-(4-diethylamino-phenyl)-1,3,4-oxdiazol, Benzildimethylketal, aromatisch substituierte Bis-trichlormethyl-s-triazine oder trichlormethylsubstituierte Carbonylmethylenheterocyclen, z. B. 2-(p-Trichlormethylbenzoylmethylen)-3-ethyl-benzthiazolin. Die Trichlormethylverbindungen werden besonders bevorzugt. Die Menge des Photoinitiators liegt im allgemeinen zwischen 0,05 und 10, bevorzugt zwischen 0,5 und 5 Gew.-%.

Als Bindemittel sind vorwiegend wasserunlösliche Polymere, wie Polyacrylate, Polymethacrylate, Polyvinylester, Polyvinylacetale, Epoxyharze und Polyurethane geeignet. Mit Vorteil werden Polymere eingesetzt, die in wäßrig-alkalischen Lösungen löslich sind, z. B. Polysulfonylurethane, Polyvinylphenol, Mischpolymerisate von Maleinsäureanhydrid oder Maleinsäurehalbestern mit Styrol, von Acryl- oder Methacrylsäure mit Alkyl(meth)acrylaten und ggf. Styrol, Acrylnitril oder dgl.

Besonders vorteilhaft sind die in der EP-A 211 391 beschriebenen Umsetzungsprodukte von intramolekularen Anhydriden mehrwertiger Carbonsäuren mit Hydroxylgruppen enthaltenden Polymeren. Das zur Herstellung dieser Produkte eingesetzte Säureanhydrid leitet sich bevorzugt von einer Di- oder Tricarbonsäure, insbesondere einer Dicarbonsäure, ab.

Beispiele für geeignete Säureanhydride sind: Maleinsäureanhydrid und Derivate, z. B. Dimethylmaleinsäureanhydrid oder Citraconsäureanhydrid, Bernsteinsäureanhydrid und Derivate, z. B. Methylbernsteinsäureanhydrid, Glutarsäureanhydrid und Derivate, z. B. 3-Methylglutarsäureanhydrid, 3,3-Tetramethylen-glutar-

4

säureanhydrid oder Camphersäureanhydrid, 3-Oxa-glutarsäureanhydrid und Derivate, Phthalsäureanhydrid und Substitutionsprodukte.

Bevorzugt werden die Reaktionsprodukte mit Malein-, Phthal-, Bernstein- und 3-Oxa-glutarsäureanhydrid.

Als Hydroxygruppen enthaltende synthetische Polymere kommen insbesondere Polymere mit Vinylalkoholeinheiten, aber auch Epoxidharze und verseifte Epoxidharze, Copolymere von Allylalkohol oder höheren ungesättigten Alkoholen, Polyhydroxyalkylacrylate und -methacrylate und ähnliche Polymerisate in Betracht.

Als Polymere mit Vinylalkoholeinheiten sind teilverseifte Polyvinylester, Polyvinylacetale mit freien Hydroxygruppen sowie entsprechende Umsetzungsprodukte von Copolymeren bzw. Copolymerisaten mit Vinylester- oder Vinylacetal- oder Vinylalkoholeinheiten geeignet. Hierzu sind auch Pfropfpolymere mit Vinylalkoholeinheiten zu zählen, wie sie z. B. in den DE-A 37 32 089 und 38 35 840 beschrieben sind.

Das Molekulargewicht der polymeren Umsetzungsprodukte liegt im allgemeinen zwischen 5.000 und etwa 200.000 und darüber, vorzugsweise zwischen 10.000 und 100.000. Die Säurezahl der Umsetzungsprodukte kann im allgemeinen zwischen 5 und 80, bevorzugt zwischen 10 und 70 liegen.

Mit besonderem Vorteil wird ein zusätzliches Bindemittel mit einer Säurezahl oberhalb 70 eingesetzt, wie es in der EP-A 381043 beschrieben ist. Es kann z. B. eine der Gruppen -COOH, $-PO_3H_2$, $-SO_3H$, $-SO_2$-NH-, $-SO_2NHSO_2$- und $-SO_2NHCO$- enthalten, wobei Carboxylgruppen bevorzugt werden. Seine Säurezahl beträgt mindestens 70, vorzugsweise 100 bis 300. Beispiele für geeignete Polymere sind Maleinatharze, Polymerisate und Copolymerisate von N-(p-Tolylsulfonyl)-carbaminsäure-$\beta$-(methacryloyloxy)-ethylester, Vinylacetat/Crotonsäure- und Styrol/Maleinsäureanhydrid- bzw. Styrol/Maleinsäurepartialester-Copolymere. Mit besonderem Vorteil werden Copolymere der Acryl- und Methacrylsäure eingesetzt. Als Comonomere sind vorzugsweise Alkyl(methyl)acrylate, Styrol, Acrylnitril u. ä. geeignet. Die Copolymeren können aus zwei oder mehreren Monomeren aufgebaut sein. Derartige Copolymere sind in der DE-C 20 64 080, der DE-A 23 63 806 und der EP-A 173 057 beschrieben.

Der Mengenanteil an diesem Polymeren beträgt im allgemeinen 1 bis 25, vorzugsweise 4 bis 15 Gew.-%, bezogen auf die nichtflüchtigen Anteile des lichtempfindlichen Gemischs. Der Anteil des Gemischs an Bindemitteln insgesamt beträgt im allgemeinen 5 bis 80, vorzugsweise 10 bis 50 Gew.-%, bezogen auf dessen nichtflüchtige Anteile.

Die erfindungsgemäßen Gemische können ferner Säuren, Inhibitoren für die thermische Polymerisation, z. B. Phenothiazin oder Di-tert.-butyl-p-kresol, Farbstoffe, Pigmente, Verlaufmittel, Weichmacher, Netzmittel und andere übliche Zusätze enthalten.

Die Gemische werden bevorzugt zur Herstellung lichtempfindlicher Druckplatten, insbesondere Flachdruckplatten, eingesetzt. In diesem Fall werden als Schichtträger vorwiegend Metalle, wie Zink, Stahl, verchromter Stahl, Messing/Chrom, Kupfer/Chrom oder Aluminium verwendet. Für Flachdruckplatten wird Aluminium bevorzugt, insbesondere mechanisch, chemisch oder elektrolytisch aufgerauhtes Aluminium, das bevorzugt noch mit einer anodisch erzeugten Oxidschicht versehen ist.

Die Gemische können auch in der Photoresisttechnik eingesetzt werden, z. B. zur Herstellung von Hoch-, Tief- oder Mehrmetalldruckplatten oder von gedruckten Schaltungen. Bei dieser Anwendung ist in vielen Fällen die erhöhte Auflösung gegenüber den sonst verwendeten photopolymerisierbaren Gemischen von besonderem Vorteil.

Bei allen Anwendungen kommen als Vorteile der erfindungsgemäßen Gemische gegenüber den bekannten Gemischen auf Basis Photopolymer/Diazoniumsalz-Kondensat eine erhöhte Lichtempfindlichkeit, erhöhte Lagerfähigkeit und geringere Klebrigkeit der Schichtoberfläche zur Geltung.

Die lichtempfindliche Schicht kann in üblicher Weise durch Aufbringen der Lösung ihrer Bestandteile auf den Schichtträger erzeugt werden. Sie kann auch zunächst auf einen temporären Schichtträger aufgebracht werden, von dem sie mechanisch abtrennbar ist, und durch Laminieren auf den endgültigen Schichtträger, z. B. eine Nickelfolie oder die Kupferschicht eines Leiterplatten-Basismaterials übertragen werden.

Bei der Verarbeitung wird das Aufzeichnungsmaterial bildmäßig durch eine Vorlage belichtet. Zur Bildbelichtung kann jede in der Reproduktionstechnik gebräuchliche Lichtquelle dienen, die im langwelligen UV-Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet. Nach der Belichtung kann die Schicht an den Bildstellen durch Erwärmen auf Temperaturen oberhalb 60 °C zusätzlich gehärtet werden.

Nach der Belichtung wird mit einem geeigneten Entwickler entwickelt. Als Entwickler können je nach der Natur des Bindemittels organische Lösemittel, ggf. ein Gemisch mit Wasser, oder rein wäßrige Lösungen eingesetzt werden. Für die Schichten mit den bevorzugten alkalilöslichen Bindemitteln werden z. B. wäßrige Netzmittellösungen, ggf. unter Zusatz von Alkali, deren Gemische mit organischen Lösemitteln, wäßrige Salzlösungen, wäßrige Lösungen von Säuren, z. B. von Phosphorsäuren, denen wiederum Salze oder organische Lösemittel zugesetzt werden können, oder wäßrig-alkalische Entwickler verwendet, z. B. wäßrige Lösungen von Natriumsalzen der Phosphorsäure oder der Kieselsäure. Auch diesen Entwicklern können organische Lösemittel zugesetzt werden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit. Dabei werden die nicht belichteten Schichtbereiche gelöst.

Die entwickelte Druckplatte kann noch zusätzlich durch Erwärmen auf eine Temperatur im Bereich von 150 - 230 °C nachgehärtet werden. Im allgemeinen reicht eine Zeit von 2 bis 20 Minuten für die Nachhärtung aus. Eine weitere Möglichkeit ist die Nachhärtung durch Belichten bzw. Bestrahlen der entwickelten Druckform.

Die nachstehenden Beispiele beschreiben die Herstellung der erfindungsgemäßen lichtempfindlichen Gemische und der mit diesen hergestellten Aufzeichnungsmaterialien. In den Beispielen stehen Gewichtsteile (Gt) und Volumenteile (Vt) zueinander im Verhältnis von g zu ml. Prozentangaben sind, wenn nichts anderes angegeben ist, Gewichtsprozente, Temperaturen sind in °C angegeben.

Beispiele 1 bis 23

Eine als Offsetdruckplattenträger geeignete Aluminiumplatte von 0,3 mm Dicke wurde elektrolytisch aufgerauht, anodisch oxydiert und mit einer wäßrigen Lösung von Polyvinylphosphonsäure behandelt.

A) Auf den so erhaltenen Schichtträger wurde eine Lösung von

| | |
|---|---|
| 0,45 Gt | eines Copolymeren aus 82 % Methylmethacrylat und 18 % Methacrylsäure (Säurezahl 117), |
| 1,50 Gt | des Umsetzungsprodukts eines Polyvinylbutyrals mit einem Molekulargewicht von 70.000 bis 80.000, das 71 % Vinylbutyral-, 2 Gew.-% Vinylacetat- und 27 Gew.-% Vinylalkoholeinheiten enthielt, mit Maleinsäureanhydrid (Säurezahl des Produkts 30), |
| 0,85 Gt | eines Diazoniumsalz-Polykondensationsprodukts aus 1 mol 3-Methoxy-diphenylamin-4-diazoniumsulfat und 1 mol 4,4'-Bis-methoxymethyl-diphenylether, ausgefällt als Mesitylensulfonat, |
| 0,20 Gt | eines blauen Kupferphthalocyaninfarbstoffs (C.I. 74170), |
| 2,60 Gt | Pentaerythrittetraacrylat/-triacrylat (technisches Gemisch), |
| 0,15 Gt | 2-(4-Styryl-phenyl)-4,6-bis-trichlormethyl-s-triazin, |
| 0,04 Gt | Phosphorsäure (85 %) und |
| 0,01 Gt | Phenylazodiphenylamin in |
| 64,20 Gt | 2-Methoxy-ethanol und |
| 30,00 Gt | Butanon |

aufgebracht und getrocknet. Das Schichtgewicht der lichtempfindlichen Schicht betrug 2,0 g/m$^2$.

B) Auf einen in gleicher Weise vorbehandelten Schichtträger wurde eine Lösung von

| | |
|---|---|
| 0,60 Gt | des unter A angegebenen Methacrylsäure-Copolymeren, |
| 1,35 Gt | des unter A angegebenen Polyvinylbutyral-Umsetzungsprodukts, |
| 0,45 Gt | des Umsetzungsprodukts eines Polyvinylbutyrals mit einem Molekulargewicht von 50.000 bis 60.000, das 70 Gew.-% Vinylbutyral-, 3 Gew.-% Vinylacetat- und 27 Gew.-% Vinylalkoholeinheiten enthielt, mit Maleinsäureanhydrid (Säurezahl 43), |
| 0,60 Gt | des unter A angegebenen Diazoniumsalz-Polykondensationsprodukts, |
| 0,30 Gt | eines blauen Kupferphthalocyanin-Farbstoffs (C.I. 74170), |
| 3,00 Gt | des Kondensationsprodukts aus 2 mol Hydroxyethylmethacrylat und 1 mol 2,2,4-Trimethylhexamethylendiisocyanat, |
| 0,15 Gt | 2-(5-Acenaphthyl)-4,6-bis-trichlormethyl-s-triazin, |
| 0,04 Gt | Phosphorsäure (85 %) und |
| 0,01 Gt | Phenylazodiphenylamin in |
| 27,00 Gt | Methanol, |
| 37,00 Gt | 1-Methoxy-propanol-(2) und |
| 29,50 Gt | Butanon |

aufgebracht. Die Schicht hatte nach dem Trocknen ein Gewicht von 2,0 g/m$^2$.

C) Auf den gleichen Schichtträger wie unter A wurde eine Lösung von

| | |
|---|---|
| 0,60 Gt | des unter A angegebenen Methacrylsäure-Copolymeren, |
| 1,35 Gt | des unter A angegebenen Polyvinylbutyral-Umsetzungsprodukts, |
| 0,45 Gt | des unter B angegebenen Polyvinylbutyral-Umsetzungsprodukts (Säurezahl 43), |

EP 0 477 686 A1

| 1,00 Gt | des unter A angegebenen Diazoniumsalz-Polykondensationsprodukts, |
|---|---|
| 0,20 Gt | Victoriareinblau FGA (C.I Basic Blue 81), |
| 2,30 Gt | des unter B angegebenen Bismethacrylats, |
| 0,15 Gt | 2-(4-Ethoxynaphthyl-(1))-4,6-bis-trichlormethyl-s-triazin, |
| 0,04 Gt | Phosphorsäure (85 %) und |
| 0,01 Gt | Phenylazodiphenylamin in |
| 30,90 Gt | Butanon, |
| 31,50 Gt | Ethanol und |
| 31,50 Gt | Diethylenglykolmonomethylether |

aufgebracht. Sie hatte nach dem Trocknen ein Schichtgewicht von 2,0 g/m$^2$.

Auf die lichtempfindlichen Schichten der so erhaltenen Druckplatten wurden wäßrige Lösungen aufgebracht, die 1,5 Gew.-% Polyvinylalkohol (Hydrolysegrad 75-79 mol-%; Polymerisationsgrad $P_n$ = 300), 0,1 Gew.-% Natriumdodecylsulfat und Phosphorsäure oder eines der in Tabelle 1 angegebenen Phosphate enthielt, und getrocknet. Das Schichtgewicht der Deckschicht betrug in jedem Falle 0,5 g/m$^2$.

## Tabelle 1

| Bei-spiel | Licht-empf. Schicht | Zusatz | Menge (g/100 g Lösung) | pH der Lösung |
|---|---|---|---|---|
| 1 (V) | A | $H_3PO_4$ (85 %) | 0,250 | 2,13 |
| 2 (V) | " | " | 0,150 | 2,68 |
| 3 | " | $NaH_2PO_4$ | 0,242 | 5,60 |
| 4 | " | $KH_2PO_4$ | 0,280 | 5,36 |
| 5 | " | $NH_4H_2PO_4$ | 0,250 | 5,32 |
| 6 | " | $Na_2HPO_4$ | 0,346 | 8,91 |
| 7 | " | $(NH_4)_2HPO_4$ | 0,285 | 8,00 |
| 8 (V) | B | $H_3PO_4$ | 0,250 | 2,13 |
| 9 | " | $NaH_2PO_4$ | 0,242 | 5,60 |
| 10 | " | $KH_2PO_4$ | 0,280 | 5,36 |
| 11 | " | $NH_4H_2PO_4$ | 0,250 | 5,32 |
| 12 | " | " | 0,500 | 5,42 |
| 13 | " | $(Me_2NH_2)H_2PO_4$ | 0,340 | 5,40 |
| 14 | " | $(NMe_4)H_2PO_4$ | 0,400 | 5,47 |

| Bei-spiel | Licht-empf. Schicht | Zusatz | Menge (g/100 g Lösung) | pH der Lösung |
|---|---|---|---|---|
| 15 | B | $Na_2HPO_4$ | 0,346 | 8,91 |
| 16 | " | $NaNH_4HPO_4$ | 0,300 | 8,45 |
| 17 | " | $(NH_4)_2HPO_4$ | 0,285 | 8,00 |
| 18 (V) | C | $H_3PO_4$ | 0,250 | 2,13 |
| 19 | " | $KH_2PO_4$ | 0,280 | 5,36 |
| 20 | " | $NH_4H_2PO_4$ | 0,250 | 5,32 |
| 21 | " | " | 0,500 | 5,42 |
| 22 | " | $NaNH_4HPO_4$ | 0,300 | 8,45 |
| 23 | " | $Ca(H_2PO_4)_2 \times H_2O$ | 0,500 | 5,80 |

V = Vergleichsbeispiel
Me = Methyl

Von den erhaltenen, mit Deckschichten versehenen Druckplatten wurde zur Untersuchung der Entwikkelbarkeit je eine Probe unmittelbar nach der Herstellung und nach Lagerung bei 100 °C im Umlufttrockenschrank unter einer Testvorlage mit einem Standard-Stufenkeil belichtet und mit der folgenden Lösung entwickelt:

3,0 Gt   Natriumdodecylsulfat,
5,4 Gt   Kaliumpelargonat,
4,0 Gt   2-Phenoxyethanol und
2,0 Gt   Kaliumtetraborat in
85,6 Gt   Wasser.

Die Entwicklung der nicht wärmebehandelten Platten erfolgte durch 15 Sekunden Tauchen in eine Küvette mit Entwicklerlösung und anschließendes Abspülen mit Wasser. Die wärmebehandelten Platten wurden mit der Entwicklerlösung übergossen und mit einem Tampon 45 Sekunden gerieben.

In der folgenden Tabelle 2 ist die Lichtempfindlichkeit, ausgedrückt durch die Zahl der gehärteten Keilstufen, vor der Lagerung bei 100 °C angegeben. Dabei bezeichnet der erste Wert die Zahl der vollständig durchgehärteten Stufen, der zweite Wert die Gesamtzahl einschließlich der teilgehärteten Stufen. Es sind weiterhin die Lagerfähigkeit der unbelichteten Platte bei 100 °C in Stunden bis zum Auftreten von Ton in den Nichtbildstellen nach dem Entwickeln und die Klebeneigung der unbelichteten Schicht angegeben. Dabei wurde zur Ermittlung der Klebeneigung ein handelsübliches Zwischenlagepapier von 45 g/m$^2$ in einer Laborpresse (Stempeldruck 5 bar, Druckdauer 1 Stunde) bei 60 % relativer Feuchte und 23 °C auf die beschichtete Oberfläche der Druckplatte gepreßt. Die Klebeneigung wurde auf einer Skala von 1 bis 8 bewertet, wobei 1 eine völlig klebefreie Schicht und 8 eine von dem Papier nicht mehr trennbare Schicht bezeichnet.

## Tabelle 2

| Bei-spiel | Keilstufen | Lagerfähig-keit bei 100 °C (Stunden) | Klebe-neigung |
|---|---|---|---|
| 1 | 10-12 | mehr als 4 | 7 |
| 2 | 7-9 | 3 | 5 |
| 3 | 8-11 | 4 | 2 |
| 4 | 8-12 | 3 | 2 |
| 5 | 7-10 | mehr als 4 | 1-2 |
| 6 | nicht entwickelbar | - | 1 |
| 7 | "          " | - | 1 |
| 8 | 11-13 | mehr als 4 | 7 |
| 9 | 9-12 | 3 | 3 |
| 10 | 9-12 | 2 | 3 |
| 11 | 8-10 | mehr als 4 | 2 |
| 12 | 9-12 | 4 | 3 |

| Bei-spiel | Keilstufen | Lagerfähig-keit bei 100 °C (Stunden) | Klebe-neigung |
|---|---|---|---|
| 13 | 8-13 | 3 | 4 |
| 14 | 8-12 | 2 | 6 |
| 15 | nicht entwickelbar | - | 2 |
| 16 | "        " | - | 1-2 |
| 17 | "        " | - | 1-2 |
| 18 | 10-12 | mehr als 4 | 6 |
| 19 | 8-11 | 3 | 1-2 |
| 20 | 7-11 | mehr als 4 | 1 |
| 21 | 9-11 | 4 | 2 |
| 22 | nicht entwickelbar | - | 1 |
| 23 | 9-11 | 4 | 3 |

Beispiele 24-27

Druckplatten wurden wie in den Beispielen 1 bis 23 beschrieben hergestellt und geprüft. Dabei wurde anstelle des dort angegebenen Polyvinylalkohols einer mit 70 % Hydrolysegrad und einem Polymerisationsgrad von 200 in der Deckschicht eingesetzt. Die Ergebnisse sind in der folgenden Tabelle 3 angegeben:

Tabelle 3

| Beispiel | Schicht | Zusatz | Menge (g/100 g Lösung) | pH | Keilstuf. | Lagerfähigkeit | Klebeneigung |
|---|---|---|---|---|---|---|---|
| 24 | A | $NaH_2PO_4$ | 0,242 | 5,60 | 8-11 | 4 | 2 |
| 25 | A | $NH_4H_2PO_4$ | 0,250 | 5,32 | 7-10 | mehr als 4 | 1-2 |
| 26 | B | $NH_4H_2PO_4$ | 0,250 | 5,32 | 8-10 | mehr als 4 | 2 |
| 27 | C | $NH_4H_2PO_4$ | 0,500 | 5,42 | 9-11 | 4 | 2 |

Wenn anstelle des oben angegebenen Polyvinylalkohols ein solcher von 85 % Hydrolysegrad und einem Polymerisationsgrad von 500 eingesetzt wurde, wurden im wesentlichen gleiche Ergebnisse erhalten.

Beispiel 28 (Vergleichsbeispiel)

Es wurde eine Druckplatte wie in Beispiel 20 beschrieben hergestellt und geprüft. Dabei wurde jedoch die Deckschicht aus einer wäßrigen Lösung beschichtet, die 0,8 % Polyvinylalkohol und 1,75 % $NH_4H_2PO_4$ enthielt. Es wurden 5-8 gehärtete Keilstufen erhalten.

**Patentansprüche**

1. Lichtempfindliches Aufzeichnungsmaterial mit einem Schichtträger, einer lichtempfindlichen Schicht, die als wesentliche Bestandteile

a) ein Diazoniumsalz-Polykondensationsprodukt,

b) eine radikalisch polymerisierbare Verbindung mit mindestens einer endständigen ethylenisch ungesättigten Gruppe und einem Siedepunkt bei Normaldruck oberhalb 100 °C,

c) einen unter Einwirkung aktinischer Strahlung Radikale bildenden Polymerisationsinitiator und

d) ein polymeres Bindemittel enthält,

und einer Deckschicht, die ein für Luftsauerstoff wenig durchlässiges wasserlösliches Polymeres enthält, dadurch gekennzeichnet, daß die Deckschicht zusätzlich ein wasserlösliches saures Phosphat enthält.

2. Lichtempfindliches Aufzeichnungsmaterial nach Anspruch 1, dadurch gekennzeichnet, daß die wäßrige Beschichtungslösung für die Deckschicht ein pH von 3 bis 7 aufweist.

3. Lichtempfindliches Aufzeichnungsmaterial nach Anspruch 1, dadurch gekennzeichnet, daß das wasserlösliche saure Phosphat ein Ammonium-, Alkali- oder Erdalkaliphosphat ist.

4. Lichtempfindliches Aufzeichnungsmaterial nach Anspruch 1, dadurch gekennzeichnet, daß das wasserlösliche saure Phosphat ein primäres Phosphat ist.

5. Lichtempfindliches Aufzeichnungsmaterial nach Anspruch 1, dadurch gekennzeichnet, daß die Deckschicht 5-50 Gew.-%, bezogen auf ihre nichtflüchtigen Bestandteile, an wasserlöslichem saurem Phosphat enthält.

6. Lichtempfindliches Aufzeichnungsmaterial nach Anspruch 3 oder 4, dadurch gekennzeichnet, daß das wasserlösliche saure Phosphat ein Natrium-, Kalium- oder Ammoniumphosphat ist.

7. Lichtempfindliches Aufzeichnungsmaterial nach Anspruch 1, dadurch gekennzeichnet, daß das für Luftsauerstoff wenig durchlässige Polymere Polyvinylalkohol ist.

8. Lichtempfindliches Aufzeichnungsmaterial nach Anspruch 1, dadurch gekennzeichnet, daß das polymere Bindemittel der lichtempfindlichen Schicht wasserunlöslich und in organischen Lösemitteln sowie in wäßrig-alkalischen Lösungen löslich ist.

9. Lichtempfindliches Aufzeichnungsmaterial nach Anspruch 8, dadurch gekennzeichnet, daß das polymere Bindemittel das Umsetzungsprodukt eines intramolekularen Anhydrids einer organischen Polycarbonsäure mit einem Hydroxylgruppen enthaltenden synthetischen Polymeren ist, das keine weiteren, zur Umsetzung mit Säureanhydriden befähigten funktionellen Gruppen enthält.

10. Lichtempfindliches Aufzeichnungsmaterial nach Anspruch 1, dadurch gekennzeichnet, daß das Diazoniumsalz-Polykondensationsproduktaus wiederkehrenden Einheiten A-N$_2$X und B besteht, die durch Zwischenglieder, vorzugsweise Methylengruppen, miteinander verbunden sind, die von kondensationsfähigen Carbonylverbindungen abgeleitet sind, wobei A der Rest einer mit Formaldehyd kondensationsfähigen aromatischen Diazoniumverbindung und B der Rest einer von Diazoniumgruppen freien, mit Formaldehyd kondensationsfähigen Verbindung, insbesondere eines aromatischen Amins, eines Phenols, Phenolethers, aromatischen Thioethers, eines aromatischen Kohlenwasserstoffs, einer aromatischen heterocyclischen Verbindung oder eines organischen Säureamids ist.

11. Lichtempfindliches Aufzeichnungsmaterial nach Anspruch 1, dadurch gekennzeichnet, daß die radikalisch polymerisierbare Verbindung ein Acryl- oder Methacrylsäureester eines mehrwertigen Alkohols ist.

12. Lichtempfindliches Aufzeichnungsmaterial nach Anspruch 1, dadurch gekennzeichnet, daß der Polymerisationsinitiator eine Verbindung mit mindestens einer photolytisch spaltbaren Trichlormethylgruppe ist.

**Europäisches Patentamt**

## EUROPÄISCHER RECHERCHENBERICHT

Nummer der Anmeldung

| | EINSCHLÄGIGE DOKUMENTE | | EP 91115457.3 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.⁵) |
| D,A | <u>EP - A - 0 381 043</u><br>(HOECHST AKTIENGESELLSCHAFT)<br>* Ansprüche; Seite 5, Zeilen 34-40 *<br>---- | 1,7,<br>10-12 | G 03 F 7/11<br>G 03 F 7/032<br>G 03 F 7/021 |

| RECHERCHIERTE SACHGEBIETE (Int. Cl.⁵) |
|---|
| G 03 F |

Der vorliegende Recherchenbericht wurde für alle Patentansprüche erstellt.

| Recherchenort | Abschlußdatum der Recherche | Prüfer |
|---|---|---|
| WIEN | 18-12-1991 | BECK |